(19) Europäisches Patentamt
European Patent Office
Office européen des brevets

(11) **EP 4 641 924 A1**

(12) **EUROPEAN PATENT APPLICATION**

(43) Date of publication:
**29.10.2025 Bulletin 2025/44**

(51) International Patent Classification (IPC):
***H03B 5/12*** *(2006.01)*

(21) Application number: **24172115.8**

(52) Cooperative Patent Classification (CPC):
**H03B 5/1228; H03B 5/12**

(22) Date of filing: **24.04.2024**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Leibniz-Institut für Festkörper- und
Werkstoffforschung Dresden e.V.
01069 Dresden (DE)**

(72) Inventors:
• **Dufouleur, Joseph
  01187 Dresden (DE)**
• **Seidemann, Torsten
  01187 Dresden (DE)**

(74) Representative: **Lippert Stachow Patentanwälte
Rechtsanwälte
Partnerschaft mbB
Krenkelstraße 3
01309 Dresden (DE)**

(54) **OSCILLATOR CIRCUIT AND METHOD OF OPERATING THE OSCILLATOR CIRCUIT**

(57) Various aspects relate to an oscillator circuit (100) and a method of operating the oscillator circuit (100), wherein the oscillator circuit (100) includes: a first node (104(1)) configured to output a first oscillating output signal; a second node (104(2)) configured to output a second oscillating output signal; a first capacitor or inductor (106(1)) coupled to the first node (104(1)); a second capacitor or inductor (106(2)) coupled to the second node (104(2)); and a first negative resistance circuit (102(1)) and a second negative resistance circuit (102(2)), wherein an input of the first negative resistance circuit (102(1)) is ohmically coupled to the first node (104(1)), and wherein an output of the first negative resistance circuit (102(1)) and an input of the second negative resistance circuit (102(2)) are ohmically coupled to the second node (104(2)).

## FIG. 1C

## Description

### Technical Field

Various aspects relate to an oscillator circuit for generating oscillating output signals and a method of operating the oscillator circuit.

### Background

In general, an electronic oscillator (short: oscillator) is an electronic circuit configured to generate an oscillator signal (e.g., an alternating current (AC) signal). For example, the oscillator may be configured to convert a direct current (DC) signal into an AC signal. An exemplary category of oscillators are linear oscillator (also referred to as harmonic oscillators) which are configured to generate the AC signal as a harmonic sine wave signal. Examples of such a linear oscillator are the feedback oscillator and the negative resistance oscillator.

A feedback oscillator includes an amplifier and a feedback loop (also referred to as a filter). If, for a given frequency $f_0$, the feedback loop is associated to zero dephasing and if it is connected to the amplifier with no sign change, the positive feedback makes the device oscillate at the frequency $f_0$. Equivalently, if the input of the amplifier is inverted, the phase accumulated at $f_0$ along the feedback loop should be $\pi$ to generate an oscillating behavior. There is several types of feedback oscillators: RC oscillators, LC oscillators, and crystal oscillators. For RC oscillators (such as an RC phase shift oscillator, a quadrature oscillator, a Wien bridge oscillator, etc.), an input of the amplifier is inverted and the phase shift is induced by a RC feedback loop. Tuning the frequency of such a circuit on purpose is more difficult than in other types of circuits, such as the LC oscillator. Small changes in the frequency of the RC oscillator can be achieved by varying a single element of the RC circuit. To tune the frequency over a wide range requires to change two or more resistor/capacitor. The Q-factor of a RC phase shift oscillator is very low due to the weak dependence of the dephasing of the feedback loop with the frequency. The quadrature oscillator uses two cascaded operational amplifier (short: opamp) integrators with a feedback loop, one with the signal applied to the inverting input or two integrators and an inverter. The advantage of the quadrature oscillator is that the sinusoidal outputs of the two operational amplifiers are 90° out of phase (in quadrature). The LC oscillator is built on similar principle as the RC phase shift oscillator. The feedback loop filter is constituted in this case by an LC circuit. The frequency is determined by a single LC circuit so only one element has to be varied to tune the frequency. The LC oscillator is nevertheless not very well adapted for frequencies below 100 kHz due to the size of the inductors and capacitors for the LC oscillator become cumbersome. The Q-factor is high (e.g., about 100). Crystal oscillators also have a high Q-factor (e.g., about $10^4$ to $10^6$) and are temperature stable, wherefore they have a better frequency stability than the RC and LC oscillators. Nevertheless, there is almost no possibility to tune the frequency of a crystal oscillators.

In the case of the negative resistance oscillator, a parasitic resistance of an LC oscillator is compensated by a negative resistance. Negative resistance oscillator are usually used at high frequency (e.g., in the GHz range) where feedback oscillators do not work very well due to a too large phase shift in the feedback loop.

These linear oscillators have various disadvantages. Some of the above-described linear oscillators may allow a voltage control by changing a capacitance using a varactor diode. However, the tuning of the frequency requires to tune several parameters and these oscillators are limited to specific frequency ranges. Further, these oscillators work for a given set of parameters which have to be adjusted.

### Brief Description of the Disclosure

Various aspects relate to an (linear) oscillator circuit and a method of operating the oscillator circuit, which solve at least some of the disadvantages of the above-described linear oscillators. The oscillator circuit is capable to generate oscillating output signals using only capacitances, resistances, and active elements (such as operational amplifiers). The oscillator circuit does not require a precise set of parameters to deliver an oscillating signal and a broad range of parameters (e.g., resistances and capacitances) lead to an oscillatory behavior with a broad range of oscillating frequencies. Thus, the oscillator circuit provides a very stable oscillator.

According to various aspects, the oscillator circuit may be a voltage-controlled oscillator allowing for a frequency modulation (which may be easily and precisely tuned). The frequency of the oscillator circuit may depend essentially on the value of some capacitances and/or resistances. The resistances can be modulated by using an active resistor (such as a voltage-controlled resistor). Therefore, the oscillator circuit may provide a stable voltage-controlled oscillator (with easy frequency control/tuning of the frequency modulation). The oscillator circuit does not require any varactor diode, wherefore a larger frequency range is achieved. The oscillator circuit naturally generates a harmonically oscillating signals with low distortion. Further, the oscillator circuit is capable to generate the oscillating signals either in-phase (i.e., not phase-shifted to one another) or out-of-phase (e.g., $\frac{\pi}{2}$ -phase-shifted to one another or with intermediate phase).

## Brief Description of the Drawings

In the drawings, like reference characters generally refer to the same parts throughout the different views. The drawings are not necessarily to scale, emphasis instead generally being placed upon illustrating the principles of the invention. In the following description, various aspects of the invention are described with reference to the following drawings, in which:

FIG. 1A to FIG.1D each show an oscillator circuit according to various aspects;
FIG.2A shows an experimentally measured oscillation generated at nodes of the oscillator circuit according to various aspects;
FIG.2B shows simulated oscillations generated at nodes of the oscillator circuit according to various aspects; and
FIG.2C and FIG.2D show simulated oscillations generated at nodes of the oscillator circuit for different numbers of circuit elements according to various aspects.

## Description

The following detailed description refers to the accompanying drawings that show, by way of illustration, specific details, and aspects in which the invention may be practiced. These aspects are described in sufficient detail to enable those skilled in the art to practice the invention. Other aspects may be utilized and structural, logical, and electrical changes may be made without departing from the scope of the invention. The various aspects are not necessarily mutually exclusive, as some aspects can be combined with one or more other aspects to form new aspects. Various aspects are described in connection with a device (e.g., an oscillator) and various aspects are described in connection with a method. However, it may be understood that aspects described in connection with a device (e.g., the oscillator) may similarly apply to the method, and vice versa.

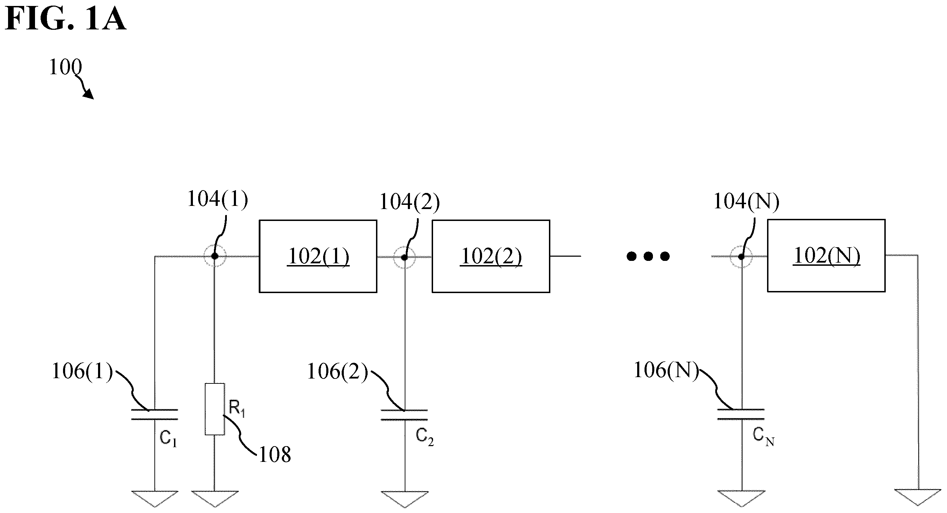

**FIG.1A** shows an oscillator circuit 100 according to various aspects.

The oscillator circuit 100 may include a plurality of negative resistance circuits 102(n = 1 to N) (with "N" being any integer number equal to or greater than two). Hence, the oscillator circuit 100 may include a number of N negative resistance circuits 102(n = 1 to N). The plurality of negative resistance circuits 102(n = 1 to N) may be (electrically) connected to each other in series.

The oscillator circuit 100 may include a plurality of nodes 104(n = 1 to N). An input of each negative resistance circuit 102(n) may be ohmically coupled to a corresponding node 104(n) of the plurality of nodes 104(n = 1 to N). Illustratively, the plurality of nodes 104(n = 1 to N) and the plurality of negative resistance circuits 102(n = 1 to N) may be arranged in an alternating sequence (starting with a first node (104(1)) and ending with an N-th negative resistance circuit 102(N). Hence, except for the N-th negative resistance circuit 102(N), each negative resistance circuit 102(n) of the other negative resistance circuits 102(n = 1 to N-1) may be arranged between two consecutive nodes 104(n), 104(n+1) of the plurality of nodes 104(n = 1 to N). Each node of the plurality of nodes 104(n = 1 to N) may be configured to output a respective oscillating output signal.

The oscillator circuit 100 may include a plurality of capacitors or inductors 106(n = 1 to N). In some aspects, all elements of the plurality of capacitors or inductors 106(n = 1 to N) are capacitors. In other aspects, all elements of the plurality of capacitors or inductors 106(n = 1 to N) are inductors. In even other aspects, some elements of the plurality of capacitors or inductors 106(n = 1 to N) are capacitors and other elements of the plurality of capacitors or inductors 106(n = 1 to N) are inductors. In the following, the plurality of capacitors or inductors 106(n = 1 to N) are described (and shown in the figures), for illustration, exemplary for a plurality of capacitors 106(n = 1 to N). However, it is understood that the aspects described exemplary for capacitors apply accordingly to inductors. Using capacitors only (i.e., the plurality of capacitors 106(n = 1 to N)) may allow an increased frequency range of the oscillations (as compared to using inductors). In this case, the frequency range of the oscillator circuit 100 may be limited by the frequency range of the operational amplifier and/or stray capacitances.

The oscillator circuit 100 may include an active or passive impedance 108. The active or passive impedance 108 may be coupled to the first node 104(n = 1). Thus, the first node 104(n = 1) may be arranged between the active or passive impedance 108 and the first negative resistance circuit 102(1).

An "active or passive impedance", as detailed herein, may be an impedance of any suitable (active or passive) circuit element or combination of (active and/or passive) circuit elements, such as an inductor (L) and/or a capacitor (C) and/or a resistor (R). Thus, it is understood, when referring to an "active or passive impedance", this may refer to one or more circuit elements providing the active or passive impedance.

In the figures, the down-pointing triangles indicate a signal ground and is a reference for all signals, voltages and currents.

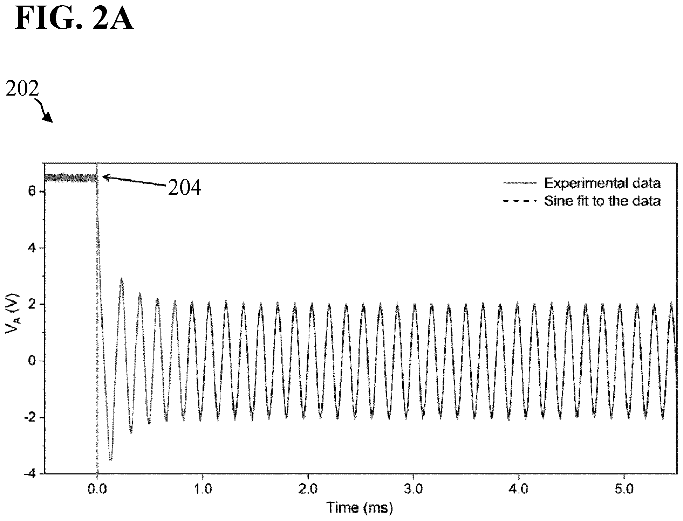

At least one node 104(n*) (e.g., each node) of the oscillator circuit 100 may be connectable (in some aspects may be (electrically conductively) connected) to one or more current sources. A current source may be configured to provide a current pulse to at least one node. The current pulse may initiate the generation of the oscillation output signals (see also FIG.2A and corresponding description). According to various aspects, a respective current pulse may be applicable (via the one or more current sources) to each node 104(n) of the plurality of nodes.

According to various aspects, the oscillator circuit 100 is a non-Hermitian oscillator. Here, a voltage vector, $\vec{V}$, is linked to an electrical current (short: current) vector, $\vec{I}$, by means of a non-Hermitian matrix, G (i.e., $\vec{I} = GV$). The voltage vector, $\vec{V}$, may include a respective voltage at each node 104(n) of the plurality of nodes 104(n = 1 to N), thus

$$\vec{V} = \begin{pmatrix} V_1 \\ V_2 \\ \vdots \\ V_N \end{pmatrix}.$$

Accordingly, the current vector, $\vec{I}$, may include a respective (electrical) current at each node 104(n) of the plurality of nodes 104(n = 1 to N), thus:

$$\vec{I} = \begin{pmatrix} I_1 \\ I_2 \\ \vdots \\ I_N \end{pmatrix}.$$

As detailed herein, in the case of a non-Hermitian matrix, G, the eigenvalues, $g_1, \dots, g_N$, of the non-Hermitian matrix, G, have a finite complex imaginary part. The non-Hermitian (conductance) matrix corresponds to a configuration without all the capacitances connecting the nodes to ground.

Since a respective capacitor 106(n) (or inductor as described herein) is connected to each node 104(n) of the plurality of nodes 104(n = 1 to N), the Kirchhoff's law determines the time evolution of the oscillator circuit 100 giving:

$$\vec{I} = G\vec{V} + Cd\vec{V}/dt,$$

wherein C is the capacitance of the respective capacitor 106(n).

If the current(s) applied to the at least one node 104(n*) vanish for $t > 0$ (with an initial current set at $t = 0$, such as via a current Heaviside step), the evolution of the respective voltage at the plurality of nodes 104(n = 1 to N) follows the equation $G\vec{V} + Cd\vec{V}/dt = \mathbf{0}$. This is a first order differential equation. With $\vec{V}_{e1}, \dots, \vec{V}_{eN}$ being the eigenvectors of the non-Hermitian matrix, G, the following equations (1) and (2) can be derived for the n-th eigenvector, $\vec{V}_{en}$:

$$g_n\vec{V}_{en} + C\frac{d\vec{V}_{en}}{dt} = 0 \qquad\qquad (1)$$

$$\vec{V}_{en} = \vec{V}_{en}(t = 0) \cdot \exp\left(-\frac{g_n}{C}t\right) \qquad\qquad (2)$$

Hence, in the case of the non-Hermitian matrix, $G$, the imaginary part of $g_n$ induces a sine (time) oscillation of the voltage (which is perfectly harmonic). A non-vanishing real part of $g_n$ induces an exponentially vanishing oscillation (for $\Re\{g_n\} > 0$) of the voltage or an exponentially increasing oscillation (for $\Re\{g_n\} < 0$).

According to various aspects, the real part of $g_n$ may be less than zero (i.e., $\Re\{g_n\} < 0$). Thereby, the respective oscillation of the voltage signal generated at the plurality of nodes 104(n = 1 to N) may exponentially increase until the active element (e.g., the operational amplifier described herein) saturates or until some dissipations are perfectly compensated. At this point, the respective oscillating output signal oscillates in a permanent and stable mode, realizing therefore a permanent oscillator. According to various aspects, the imaginary part may be larger than the real part in absolute value (e.g., to generate the oscillation(s) described herein).

**FIG.2A** illustrates a graph 202 showing an experimentally measured oscillating output signal (straight line) at a node 104(n*) responsive to applying a current pulse (with an end 204 of the current pulse). The graph 202 further shows a sine fit (dashed line) to the experimentally measured oscillating output signal. Illustratively, the graph 202 shows a sine (time) oscillation of the voltage at the node 104(n*) starting from about 1 millisecond (ms) after the end 204 of the current pulse. In some aspects, the current pulse may have a time duration less than 1 ms (e.g., in the in the microsecond ($\mu$s) time range). In this case, the slow rising amplitude of the oscillating output signal can be achieved. In other aspects, the current pulse may have a time duration less than 1 s (e.g., in the ms time range). In this case, the full amplitude of the oscillating output signal can be achieved.

It has been found that, in the case that an active or passive resistor 110(n*, 3) of a negative resistance circuit 102(n*) (e.g., the active or passive resistor 110(1, 3) of the first negative resistance circuit 102(1)) is less than about 15 Ohm, the oscillation starts immediately after the power is switched on (e.g., without any current pulse which, however, may also depend on other parameters, such as a respective value of the other resistances). Hence, in this case no current source may be required.

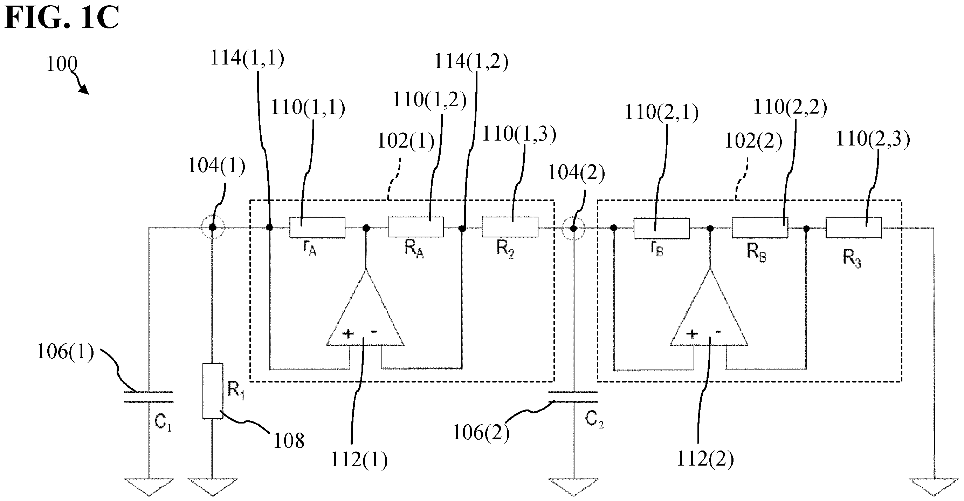

According to various aspects, the active or passive resistor 1 10(n*, 3) of at least one negative resistance circuit 102(n*) and/or the active or passive impedance 108 may be an active resistor (e.g., a voltage-controlled resistor). This may allow a frequency modulation of the generated oscillating output signals. Thus, in the case that at least one negative resistance circuit 102(n*) and/or the active or passive impedance 108 is an active resistor, the oscillator circuit 100 is a voltage-controlled oscillator. Herein, the *-notation may define one specific integer for the corresponding variable, such as a specific n* for the variable n. For example, in the exemplary configuration shown in FIG.1C, at least one of the resistances $R_1$, $R_2$ and/or $R_3$ may be controllable. Thereby, a voltage-controlled oscillator can be realized without any varactor diode.

In accordance with the above-described principles, a method may include applying a (electrical) current pulse to the at least one node 104(n*) (e.g., each node) of the oscillator circuit 100 (to start the generation of the oscillation output signals).

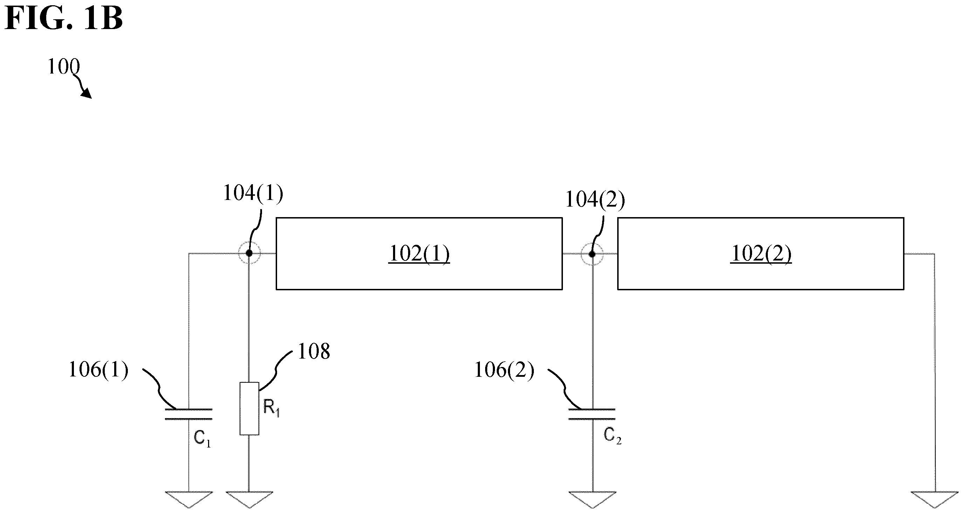

**FIG.1B** shows an exemplary configuration of the oscillator circuit 100 for N = 2. The oscillator circuit 100 may be configured to generate a first oscillating output signal output by the first node 104(1) and a second oscillating output signal output by the second node 104(2). In the following, various aspects are described exemplarily for N = 2. It is understood that this serves for illustration of the disclosed principles and the described aspects apply accordingly to the oscillator circuit 100 for N ≥ 3.

In an exemplary configuration, as shown in **FIG.1C,** a respective negative resistance circuit 102(n) may include an operational amplifier 112(n) (as an active element). It is understood that this exemplary configuration serves as illustration of the principles disclosed herein and that the negative resistance circuit may have any other configuration and/or including (additionally or alternatively) another active element (e.g., including one or more transistors). The exemplary negative resistance circuit 102(n) may include a first feedback node 114(n, 1) and a second feedback node 114(n, 2). The first feedback node 114(n, 1) may be coupled to the input of the negative resistance circuit 102(n) and to a first (e.g., non-inverting) input (+) of the operational amplifier 112(n). The second feedback node 114(n, 2) may be coupled to a second (e.g., inverting) input (-) of the operational amplifier 112(n). The exemplary negative resistance circuit 102(n) may include a first resistor 110(n, 1) coupled to and arranged between the first feedback node 114(n, 1) and an output of the operational amplifier 112(n). The exemplary negative resistance circuit 102(n) may include a second resistor 110(n, 2) coupled to and arranged between the second feedback node 114(n, 2) and the output of the operational amplifier 112(n). The exemplary negative resistance circuit 102(n) may include an active or passive resistor 110(n, 3) coupled to and arranged between the second feedback node 114(n, 2) and the output of the negative resistance circuit 102(n).

Depending on the parameters of the oscillator circuit 100, the oscillating output signals may be in-phase (i.e., not phase-shifted) or out-of-phase (i.e., phase-shifted, in some aspects also referred as dephased) to each other. In the following, this is detailed exemplarily for the exemplary configuration of the oscillator circuit 100 for N = 2, as shown in FIG. 1C.

Considering the linkage of the voltage vector, $\vec{V}$, and the current vector, $\vec{I}$, via the non-Hermitian matrix, G, without considering the capacitor connecting each node to ground as detailed above (i.e., $\vec{I} = G\vec{V}$), equation (3) can be derived for the oscillator circuit 100 of FIG.1C:

$$\begin{pmatrix} I_1 \\ I_2 \end{pmatrix} = G \begin{pmatrix} V_1 \\ V_2 \end{pmatrix} = \begin{pmatrix} \frac{1}{R_2} - \frac{1}{R_1} & -\frac{1}{R_2} \\ \frac{1}{R_2} & \frac{1}{R_3} - \frac{1}{R_2} \end{pmatrix} \begin{pmatrix} V_1 \\ V_2 \end{pmatrix} \qquad (3)$$

When defining equations (4) and (5):

$$b = \frac{1}{R_1} + \frac{1-\alpha}{R_2} - \frac{\beta}{R_3} \qquad (4)$$

$$\Delta = \frac{1}{R_1{}^2} + \frac{(1-\alpha)^2}{R_2{}^2} + \frac{\beta^2}{R_3{}^2} - \frac{2(3-\alpha)}{R_1 R_2} + \frac{2\beta}{R_1 R_3} + \frac{2\beta(1-3\alpha)}{R_2 R_3} \qquad (5)$$

stable oscillations can be achieved for $\Delta < 0$ and $b \lesssim 0$.

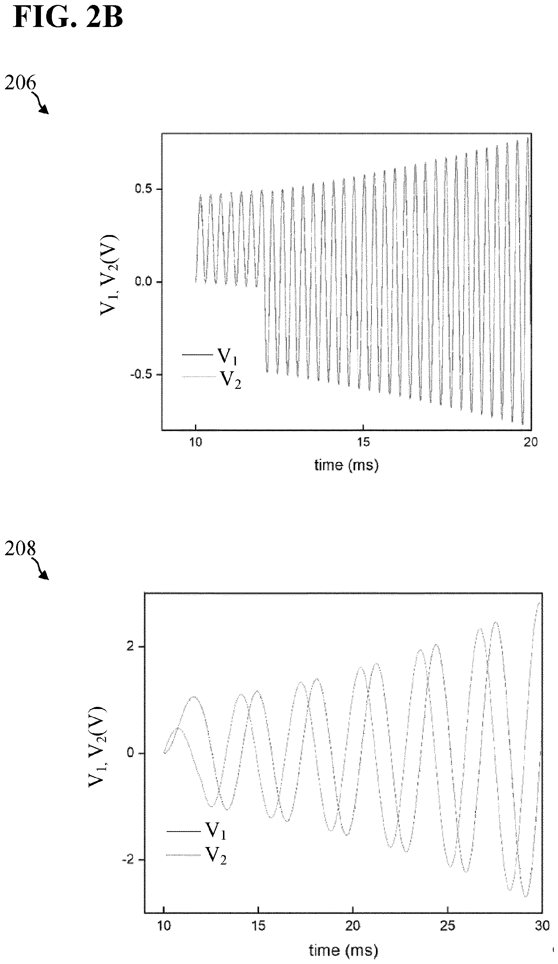

In the case that $R_2{}^{-1} \gg R_3{}^{-1} > R_1{}^{-1}$, the oscillating output signals at the first node 104(1) and the second node 104(2) are in-phase. Graph 206 in **FIG.2B** shows simulated oscillating output signals for such a scenario (with $R_1 = 5k\Omega$, $R_2$ = 200Ω, $R_3$ = 4,5kΩ,

$$C = 100nF, \ \alpha = \frac{R_A}{r_A} = \frac{1k\Omega}{1k\Omega} = 1, \ \beta = \frac{R_B}{r_B} = \frac{1k\Omega}{1k\Omega} = 1)$$

.

In the case that $R_1 = R_2 \gtrsim R_3$, the oscillating output signals at the first node 104(1) and the second node 104(2) are out-of-phase. Graph 208 in FIG.2B shows simulated oscillating output signals for such a scenario (with $R_1 = 5k\Omega$, $R_2 = 5k\Omega$,
$R_3$ = 4,5kΩ, $C$ = 100nF ,

$$\alpha = \frac{R_A}{r_A} = \frac{1k\Omega}{1k\Omega} = 1, \ \beta = \frac{R_B}{r_B} = \frac{1k\Omega}{1k\Omega} = 1)$$

.

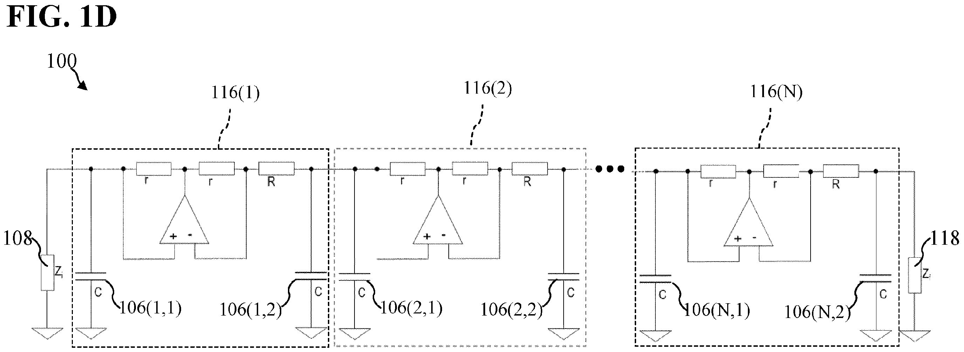

As detailed with reference to FIG. 1A, in some aspects the oscillator circuit 100 may include more than two negative resistance circuits (i.e., N > 2). **FIG.1D** shows an exemplary configuration of the oscillator circuit 100 for N > 2, wherein each negative resistance circuit 102(n) is configured as described with reference to FIG.1C. In this exemplary configuration, the oscillator circuit 100 may include a plurality of circuit elements 116(n = 1 to N) which are connected in series. Each circuit element 116(n) may include a respective one 102(n) of the plurality of negative resistance circuits 102(n = 1 to N). Each circuit element 116(n) may include a first capacitor 106(n, 1) (or inductor) coupled to an input of the circuit element 116(n) and a second capacitor 106(n, 2) (or inductor) coupled to an output of the circuit element 116(n). A circuit element 116(n) may also be referred to as unit cell of the oscillator circuit 100.

Each circuit element 116(n) is shown and described as having a respective first capacitor 106(n, 1) and a respective second capacitor 106(n, 2). It is understood that this serves for illustration and that the second capacitor 106(n*, 2) of a circuit element 116(n*) and the first capacitor 116(n*+1), 1) of a subsequent circuit element 116(n*+1) can be provided by a single capacitor. Thus, at least one capacitor may be coupled to each node 104(n) of the plurality of nodes 104(n = 1 to N).

Optionally, the oscillator circuit 100 described herein may include a further active or passive impedance coupled to an output of the last negative resistance circuit 102(N) (e.g., an output of the last circuit element 116(N) in the case of the oscillator circuit 100 configured according to FIG.1D). An exemplary further active or passive impedance, $Z_f$, 118 is shown in FIG.1D.

Illustratively, the plurality of circuit elements 116(n = 1 to N) are arranged in a chain, thereby forming a kind of wave guide with specific boundary conditions. These specific boundary conditions may be given by a (first) impedance, Zi, of the active or passive impedance 108 (hence, an impedance at the beginning of the chain) and by a (second) impedance, Zf, of the further active or passive impedance 118 (hence, an impedance at the end of the chain).

By this, a multi-operational amplifier chain is provided showing oscillations of voltages on each node of the plurality of nodes 104(n = 1 to N) (hence, with a node being prior to the first circuit elements 116(1) and between two consecutive circuit elements 116(n), 116(n+1). Here, the oscillating output signal at each node 104(n) has a finite phase.

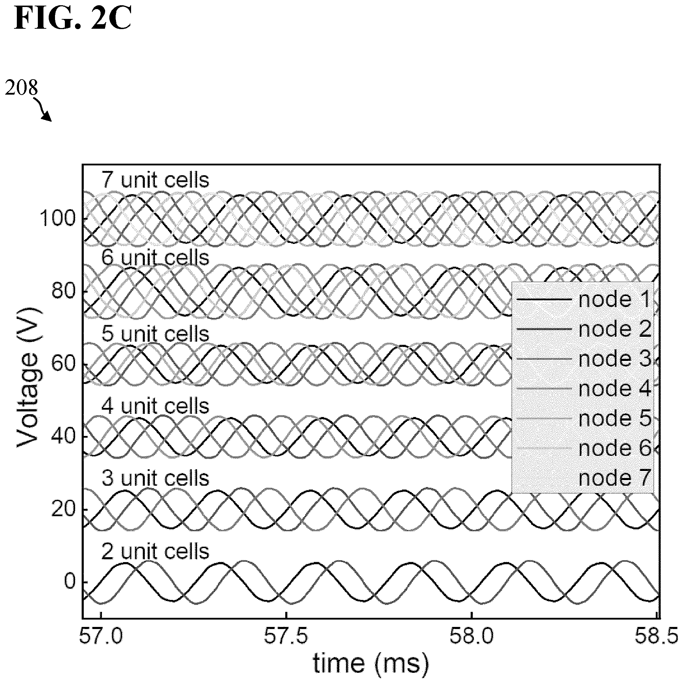

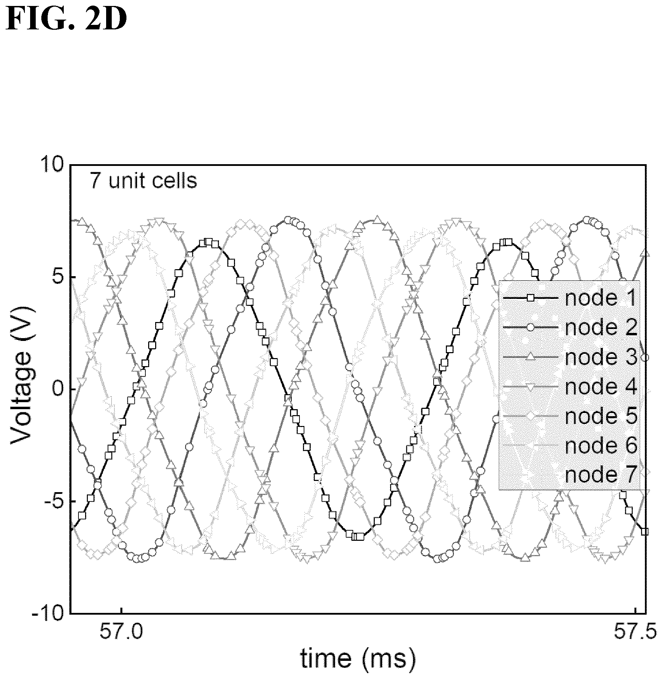

**FIG.2C** illustrates a graph 208 showing simulated oscillations generated at the nodes of the oscillator circuit 100 for different numbers of circuit elements (viz. for N =2, N =3, N =4, N =5, N =6, and N =7). Illustratively, graph 208 shows that the oscillating output signals generated at the N nodes may be dephased to one another. This simulation has been carried out for C= 10nF, $r$ = 1500Ω, $R$ = 1500Ω (using boundary conditions $Z_i$ = 1500Ω // 10nF and $Z_f$ = 0Ω). **FIG.2D** shows a detailed view of the simulated oscillations generated at the nodes of the oscillator circuit 100 for N = 7.

The principles described herein are applicable in different fields. According to various aspects, the oscillator circuit 100 does not include any varactor diode. This is achieved in that the oscillator circuit 100 includes at least one active resistor (e.g., a voltage-controlled resistor) allowing for a change of resistivity, thereby allowing for a frequency modulation of the oscillating output signals.

In the following, various examples are provided that may include one or more aspects described above with reference to the oscillator circuit 100 and/or the method. It may be intended that aspects described in relation the oscillator circuit may apply also to the method, and vice versa.

Example 1 is an oscillator circuit for generating oscillating output signals, the oscillator circuit including: a first node configured to output a first oscillating output signal; a second node configured to output a second oscillating output signal; a first capacitor or inductor coupled to the first node; a second capacitor or inductor coupled to the second node; and a first negative resistance circuit and a second negative resistance circuit, wherein an input of the first negative resistance circuit is ohmically coupled to the first node, and wherein an output of the first negative resistance circuit and an input of the second negative resistance circuit are ohmically coupled to the second node.

In Example 2, the subject matter of Example 1 can optionally include that a voltage vector, which includes a first voltage at the first node and a second voltage at the second node, is linked to a (electrical) current vector, which includes a first (electrical) current applied to the first node by a first current source and a second (electrical) current applied to the second node by a second current source, by means of a non-Hermitian matrix. In some aspects, the voltage vector further includes a third voltage at an output node of the second negative resistance circuit and the current vector may include a third current applied to the output node by a third current source. Optionally, a circuitry may include the oscillator circuit, the first current and the second current source (and optionally further the third current source).

In Example 3, the subject matter of Example 1 or 2 can optionally include that the first oscillating output signal has a first phase and wherein the second oscillating output signal has a second phase different from the first phase. Illustratively, the first oscillating output signal and the second oscillating output signal are phased-shifted (in some aspects referred to as dephased) to each other.

In Example 4, the subject matter of any one of Examples 1 to 3 can optionally include that the first negative resistance circuit and the second negative resistance circuit each includes at least one active circuit element (e.g., an operational amplifier and/or a transistor).

In Example 5, the subject matter of any one of Examples 1 to 4 can optionally include that a respective negative resistance circuit of the first negative resistance circuit and/or the second negative resistance circuit includes: an operational amplifier; a first feedback node coupled an input of the respective negative resistance circuit and to a first (e.g., non-inverting) input of the operational amplifier; a second feedback node coupled to a second (e.g., inverting) input of the operational amplifier; a first resistor coupled to and arranged between the first feedback node and an output of the operational amplifier; a second resistor coupled to and arranged between the second feedback node and the output of the operational amplifier; and an active or passive resistor coupled to and arranged between the second feedback node and the output of the respective negative resistance circuit.

In Example 6, the subject matter of Example 5 can optionally include that the active or passive resistor is a passive resistor; or wherein the active or passive resistor is an active voltage-controlled resistor.

In Example 7, the subject matter of Example 5 or 6 can optionally include that the active or passive resistor of the first negative resistance circuit has a resistance value less than about 15 Ohm.

In Example 8, the oscillator circuit of any one of Examples 1 to 7 can optionally further include: an active or passive impedance (e.g., the active or passive impedance 108) coupled to the first node, wherein the first node is arranged between the active or passive impedance and the first negative resistance circuit.

In Example 9, the subject matter of Example 8 can optionally include that the active or passive impedance is a passive resistor or an active voltage-controlled resistor.

In Example 10, the subject matter of any one of Examples 1 to 9 can optionally include that the oscillator circuit does not include a varactor diode.

Example 11 is an oscillator circuit for generating oscillating output signals, the oscillator circuit including: a first node configured to output a first oscillating output signal; a second node configured to output a second oscillating output signal; a first inductor coupled to the first node; a second inductor coupled to the second node; and a first negative resistance circuit and a second negative resistance circuit, wherein an input of the first negative resistance circuit is ohmically coupled to the first node, and wherein an output of the first negative resistance circuit and an input of the second negative resistance circuit are ohmically coupled to the second node.

Example 12 is a circuitry including: the oscillator circuit according to any one of Examples 1 to 11; and a current source configured to provide (e.g., supply) a (electrical) current pulse (e.g., having a pulse duration less than one second, such as a pulse duration less than one millisecond) to the first node and/or the second node.

Example 13 is an oscillator circuit for generating oscillating output signals, the oscillator circuit including: a plurality of nodes, wherein each node of the plurality of nodes is configured to output a respective oscillating output signal; a plurality of circuit elements which are connected in series, wherein the plurality of nodes and the plurality of circuit elements are arranged in an alternating sequence with each circuit element (116(n)) of the plurality of circuit elements (116(n = 1 to N)) being coupled between two consecutive nodes (104(n), 104(n+1)) of the plurality of nodes (104(n = 1 to N+1)), wherein each circuit element of the plurality of circuit elements includes a respective negative resistance circuit, wherein an input of the respective negative resistance circuit is ohmically coupled to a first node of the two consecutive nodes and wherein an output of the respective negative resistance circuit is ohmically coupled to a second node of the two consecutive nodes; and a plurality of capacitors or inductors, wherein each capacitor or inductor of the plurality of capacitors or inductors is coupled to a corresponding node of the plurality of nodes.

In Example 14, the subject matter of Example 13 can optionally include that a voltage vector, which includes a respective voltage at each node of the plurality of nodes, is linked to a (electrical) current vector, which includes a respective (electrical) current applied to each node of the plurality of nodes by a respective current source (of a plurality of current sources), by means of a non-Hermitian matrix.

In Example 15, the subject matter of Example 13 or 14 can optionally include that the oscillating output signals are phase-shifted (i.e., dephased) with respect to each other.

In Example 16, the subject matter of any one of Examples 13 to 15 can optionally include that the respective negative resistance circuit includes at least one active circuit element (e.g., an operational amplifier and/or a transistor).

In Example 17, the subject matter of any one of Examples 13 to 16 can optionally include that the respective negative resistance circuit includes: an operational amplifier; a first feedback node coupled the input of the negative resistance circuit and to a first (e.g., non-inverting) input of the operational amplifier; a second feedback node coupled to the output of the negative resistance circuit and a second (e.g., inverting) input of the operational amplifier; a first resistor coupled to and arranged between the first feedback node and an output of the operational amplifier; a second resistor coupled to and arranged between the second feedback node and the output of the operational amplifier; and an active or passive resistor coupled to and arranged between the second feedback node and the output of the respective negative resistance circuit.

In Example 18, the subject matter of Example 17 can optionally include that the active or passive resistor is a passive resistor; or wherein the active or passive resistor is an active voltage-controlled resistor.

In Example 19, the subject matter of Example 17 or 18 can optionally include that the active or passive resistor has a resistance value less than about 15 Ohm.

In Example 20, the oscillator circuit of any one of Examples 13 to 19 can optionally further include: an active or passive impedance coupled to a node of the plurality of nodes, wherein the node is arranged between the active or passive impedance and a first one of the plurality of circuit elements according to an order of the series connection of the plurality of circuit elements.

In Example 21, the subject matter of Example 20 can optionally include that the active or passive impedance is a passive resistor or an active voltage-controlled resistor.

In Example 22, the subject matter of any one of Examples 13 to 21 can optionally include that the oscillator circuit does not include a varactor diode.

Example 23 is a circuitry including: the oscillator circuit according to any one of Examples 13 to 22; and a current source configured to provide (e.g., supply) a (electrical) current pulse (e.g., having a pulse duration less than one second, such as a pulse duration less than one millisecond) to at least one node of the plurality of nodes. In some aspects, the circuitry may include a plurality of current sources, wherein each current source of the plurality of current sources is configured to provide (e.g., apply) a current pulse to a corresponding node of the plurality of nodes.

Example 24 is a method of operating an oscillator circuit, the method including: applying a (electrical) current pulse to at least one node of the oscillator circuit according to any one of Examples 1 to 23 (e.g., to the first node and/or the second node provided that in combination with any one of Examples 1 to 12; or to at least one node of the plurality of nodes provided that in combination with any one of Examples 13 to 23). In some aspects, a respective current pulse may be applied to each node of the plurality of nodes of the oscillator circuit.

Various aspects described herein relate to a "non-Hermitian matrix". A non-Hermitian matrix is a matrix that is not Hermitian. A Hermitian matrix (also referred to as self-adjoint matrix) is a complex square matrix that is equal to its own conjugate transpose. Thus, in a Hermitian matrix, a matrix-element in the i-th row and j-th column is equal to the complex conjugate of the element in the j-th row and i-th column, for all indices i and j. Hence, a Hermitian matrix A fulfills $A = A^H$ with $A^H$ being the conjugate transpose (also referred to as Hermitian transpose) of the matrix A. Therefore, a non-Hermitian matrix does not fulfill this requirement. For example, in the case of a non-Hermitian matrix B: $B \neq B^H$. Therefore, a non-Hermitian matrix can not be transformed by an orthogonal matrix to diagonal form; thus, a non-Hermitian matrix does not have an orthogonal set of eigenvectors.

Various aspects described herein relate components or elements of a circuit (e.g., the oscillator circuit). It is understood that the components or elements of the circuit are electrical components. Thus, a resistor described herein may also be referred to as an electrical resistor, an inductor described herein may also be referred to as an electrical inductor, etc. Accordingly, a current described herein is understood to be an electrical current.

Various aspects relate to components or elements of the circuit being connected and/or coupled to one another. If not explicitly described otherwise, the components or elements are electrically and/or ohmically connected and/or coupled to one another.

An "active circuit element" (short: active element), as described herein, may be configured to receive a physical input and to output a physical output which is a modification of the physical input (e.g., the physical output may be different, e.g., increased or decreased, with respect to the physical input). According to various aspects, the active element may include or may be an operational amplifier, such as a voltage amplifier, a current amplifier, etc.

A "negative resistance circuit", as described herein, may include an active element. Therefore, a negative resistance circuit may also be referred to as active circuit. A negative resistance circuit may be a circuit having an input resistance, $R_{in}$, negative to a resistance, R, of the circuit (i.e., Rin=-R). In a negative resistance circuit, an increase of a voltage value of a voltage across the input and the output of the negative resistance circuit may result in a decrease of an electrical current through the negative resistance circuit.

Various aspects described herein relate to a node a circuit (e.g., a node of an oscillator circuit). A "node", as described herein, may be connected to different elements. A node may be a splitting point and/or a merging point of a connection line (e.g., a wire). Thus, in general, a node may be any region between at least two circuit elements. The at least two circuit elements which are connected to each other via a node, may be subjected to the same physical property (e.g., the same electric potential, e.g., the same electrical voltage). The at least two circuit elements may be connected to each other via one or more electrical connection lines. An electrical connection line may be electrically conducting (e.g., may have an electric conductivity greater than $10^5$ S/m (e.g., at 20°C and 1 bar)).

While the invention has been particularly shown and described with reference to specific aspects, it should be understood by those skilled in the art that various changes in form and detail may be made therein without departing from the spirit and scope of the invention as defined by the appended claims. The scope of the invention is thus indicated by the appended claims and all changes, which come within the meaning and range of equivalency of the claims, are therefore intended to be embraced.

**Claims**

1.  An oscillator circuit (100) for generating oscillating output signals, the oscillator circuit (100) comprising:

    • a first node (104(1)) configured to output a first oscillating output signal;
    • a second node (104(2)) configured to output a second oscillating output signal;
    • a first capacitor or inductor (106(1)) coupled to the first node (104(1));
    • a second capacitor or inductor (106(2)) coupled to the second node (104(2)); and
    • a first negative resistance circuit (102(1)) and a second negative resistance circuit (102(2)), wherein an input of the first negative resistance circuit (102(1)) is ohmically coupled to the first node (104(1)), and wherein an output of the first negative resistance circuit (102(1)) and an input of the second negative resistance circuit (102(2)) are ohmically coupled to the second node (104(2)).

2.  The oscillator circuit (100) according to claim 1,
    wherein a voltage vector, which comprises a first voltage at the first node (104(1)) and a second voltage at the second node (104(2)), is linked to a current vector, which comprises a first current applied to the first node (104(1)) by a first current source and a second current applied to the second node (104(2)) by a second current source, by means of a non-Hermitian matrix.

3.  The oscillator circuit (100) according to claim 1 or 2,
    wherein the first oscillating output signal has a first phase and wherein the second oscillating output signal has a second phase different from the first phase.

4.  The oscillator circuit (100) according to any one of claims 1 to 3,
    wherein the first negative resistance circuit (102(1)) and the second negative resistance circuit (102(2)) each comprises at least one active circuit element.

5.  The oscillator circuit (100) according to any one of claims 1 to 4,
    wherein a respective negative resistance circuit (102(n)) of the first negative resistance circuit (102(1)) and/or the second negative resistance circuit (102(2)) comprises:

    • an operational amplifier (112(n));
    • a first feedback node (114(n, 1)) coupled an input of the respective negative resistance circuit (102(n)) and to a first input of the operational amplifier (112(n));
    • a second feedback node (114(n, 2)) coupled to a second input of the operational amplifier (112(n));
    • a first resistor (110(n, 1)) coupled to and arranged between the first feedback node (114(n, 1)) and an output of the operational amplifier (112(n));
    • a second resistor (110(n, 2)) coupled to and arranged between the second feedback node (114(n, 1)) and the output of the operational amplifier (112(n)); and
    • an active or passive resistor (110(n, 3)) coupled to and arranged between the second feedback node (114(n, 2)) and the output of the respective negative resistance circuit (102(n)).

6.  The oscillator circuit (100) according to claim 5,

wherein the active or passive resistor (110(n, 3)) is a passive resistor; or
wherein the active or passive resistor (110(n, 3)) is an active voltage-controlled resistor.

7. The oscillator circuit (100) according to claim 5 or 6,
wherein the active or passive resistor (110(1,3)) of the first negative resistance circuit (102(1)) has a resistance value less than about 15 Ohm.

8. The oscillator circuit (100) according to any one of claims 1 to 7, further comprising:

   • an active or passive impedance (108) coupled to the first node (104(1)), wherein the first node (104(1)) is arranged between the active or passive impedance (108) and the first negative resistance circuit (102(1)).

9. The oscillator circuit (100) according to claim 8,
wherein the active or passive impedance (108) is a passive resistor or an active voltage-controlled resistor.

10. The oscillator circuit (100) according to any one of claims 1 to 9,
wherein the oscillator circuit (100) does not comprise a varactor diode.

11. A circuitry, comprising:

   • the oscillator circuit (100) according to any one of claims 1 to 10; and
   • a current source configured to provide a current pulse to the first node (104(1)) and/or the second node (104(2)).

12. An oscillator circuit (100) for generating oscillating output signals, the oscillator circuit (100) comprising:

   a plurality of nodes (104(n = 1 to N+1)), wherein each node (104(n)) of the plurality of nodes (104(n = 1 to N+1)) is configured to output a respective oscillating output signal;
   a plurality of circuit elements (116(n = 1 to N)) which are connected in series, wherein the plurality of nodes (104(n = 1 to N+1)) and the plurality of circuit elements (116(n = 1 to N)) are arranged in an alternating sequence with each circuit element (116(n)) of the plurality of circuit elements (116(n = 1 to N)) being coupled between two consecutive nodes (104(n), 104(n+1)) of the plurality of nodes (104(n = 1 to N+1)), wherein each circuit element (116(n)) of the plurality of circuit elements (116(n = 1 to N)) comprises a respective negative resistance circuit (102(n)), wherein an input of the respective negative resistance circuit (102(n)) is ohmically coupled to a first node (104(n)) of the two consecutive nodes (104(n), 104(n+1)) and wherein an output of the respective negative resistance circuit (102(n)) is ohmically coupled to a second node (104(n+1)) of the two consecutive nodes (104(n), 104(n+1)); and
   a plurality of capacitors or inductors (106(n = 1 to N+1)), wherein each capacitor or inductor (106(n)) of the plurality of capacitors or inductors (106(n = 1 to N+1)) is coupled to a corresponding node (104(n)) of the plurality of nodes (104(n = 1 to N+1)).

13. The oscillator circuit (100) according to claim 12,
wherein a voltage vector, which comprises a respective voltage at each node of the plurality of nodes (104(n = 1 to N+1)), is linked to a current vector, which comprises a respective current applied to each node of the plurality of nodes (104(n = 1 to N+1)) by a respective current source, by means of a non-Hermitian matrix.

14. The oscillator circuit (100) according to claim 12 or 13,
wherein the respective negative resistance circuit (102(n)) comprises:

   • an operational amplifier (112(n));
   • a first feedback node (114(n, 1)) coupled to the input of the negative resistance circuit (102(n)) and to a first input of the operational amplifier (112(n));
   • a second feedback node (114(n, 2)) coupled to the output of the negative resistance circuit (102(n)) and a second input of the operational amplifier (112(n));
   • a first resistor (110(n, 1)) coupled to and arranged between the first feedback node (114(n, 1)) and an output of the operational amplifier (112(1));
   • a second resistor (110(n, 2)) coupled to and arranged between the second feedback node (114(n, 2)) and the output of the operational amplifier (112(2)); and
   • an active or passive resistor (110(n, 3)) coupled to and arranged between the second feedback node (114(n, 1)) and the output of the negative resistance circuit.

**15.** A method of operating an oscillator circuit (100), the method comprising: applying a current pulse to at least one of the nodes (104(n = 1 to N)) of the oscillator circuit (100) according to any one of claims 1 to 14.

EP 4 641 924 A1

# FIG. 1A

FIG. 1B

100

104(1)

104(2)

102(1)

102(2)

108

106(1)

$C_1$

$R_1$

106(2)

$C_2$

EP 4 641 924 A1

FIG. 1C

EP 4 641 924 A1

## FIG. 1D

EP 4 641 924 A1

# FIG. 2A

202

204

Experimental data
- - - - Sine fit to the data

# FIG. 2B

206

208

# FIG. 2C

208

# FIG. 2D

**Europäisches Patentamt**
**European Patent Office**
**Office européen des brevets**

# EUROPEAN SEARCH REPORT

Application Number

EP 24 17 2115

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/264996 A1 (CHANG CHUN-MING [TW] ET AL) 21 October 2010 (2010-10-21) | 1-4,10, 12,13 | INV. H03B5/12 |
| A | * figures 4B, 5 * | 5-7,14 | |
| X | US 8 558 625 B1 (LIE YU-CHUN DONALD [US] ET AL) 15 October 2013 (2013-10-15) | 1,4,8, 12,15 | |
| A | * figure 5C * | 5-7,14 | |
| X | US 2017/104455 A1 (TOHIDIAN MASSOUD [NL] ET AL) 13 April 2017 (2017-04-13) | 1,4, 9-12,15 | |
| A | * paragraph [0081]; figures 9A, 17B * | 5-7,14 | |
| X | US 2008/030282 A1 (MAGET JUDITH [DE] ET AL) 7 February 2008 (2008-02-07) | 1,4,12, 15 | |
| A | * paragraph [0210]; figure 6 * | 5-7,14 | |

**TECHNICAL FIELDS SEARCHED (IPC)**

H03B
H03K

The present search report has been drawn up for all claims

| Place of search | Date of completion of the search | Examiner |
|---|---|---|
| Munich | 18 October 2024 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 2115

This annex lists the patent family members relating to the patent documents cited in the above-mentioned European search report.
The members are as contained in the European Patent Office EDP file on
The European Patent Office is in no way liable for these particulars which are merely given for the purpose of information.

18-10-2024

| Patent document cited in search report | | Publication date | Patent family member(s) | | Publication date |
|---|---|---|---|---|---|
| US 2010264996 | A1 | 21-10-2010 | EP | 2244374 A2 | 27-10-2010 |
| | | | JP | 5815925 B2 | 17-11-2015 |
| | | | JP | 2010252337 A | 04-11-2010 |
| | | | KR | 20100115717 A | 28-10-2010 |
| | | | TW | 201108620 A | 01-03-2011 |
| | | | US | 2010264996 A1 | 21-10-2010 |
| US 8558625 | B1 | 15-10-2013 | NONE | | |
| US 2017104455 | A1 | 13-04-2017 | US | 2015372665 A1 | 24-12-2015 |
| | | | US | 2017104455 A1 | 13-04-2017 |
| US 2008030282 | A1 | 07-02-2008 | DE | 10345195 A1 | 28-04-2005 |
| | | | EP | 1668772 A1 | 14-06-2006 |
| | | | US | 2008030282 A1 | 07-02-2008 |
| | | | WO | 2005041402 A1 | 06-05-2005 |

EPO FORM P0459

For more details about this annex : see Official Journal of the European Patent Office, No. 12/82